# EUROPÄISCHE PATENTSCHRIFT

(11) **EP 1 683 402 B1**
(45) Veröffentlichungstag und Bekanntmachung des Hinweises auf die Patenterteilung: **07.03.2007**
(21) Anmeldenummer: 04790141.8
(22) Anmeldetag: 06.10.2004
(51) Int. Cl.: H05K 7/14, H02J 13/00

(54) **SCHIENENVERTEILERSYSTEM**
BUSBAR TRUNKING SYSTEM
SYSTEME DE DISTRIBUTEUR A BARRES COLLECTRICES

(30) Priorität: 03.11.2003 DE 10351532
(43) Veröffentlichungstag der Anmeldung: 26.07.2006
(73) Patentinhaber: Sew-Eurodrive GmbH & Co. KG, 76646 Bruchsal (DE)
(72) Erfinder: MAHLEIN, Jochen, 76139 Karlsruhe (DE); LAUBENSTEIN, Udo, 76297 Stutensee (DE); SCHMIDT, Josef, 76676 Graben-Neudorf (DE)
(86) Internationale Anmeldenummer: PCT/EP2004/011145
(87) Internationale Veröffentlichungsnummer: WO 2005/048671

(56) Entgegenhaltungen:
- DE-A1- 19 905 952
- DE-U1- 9 417 134
- US-A- 5 465 395
- US-A- 5 637 933
- US-A1- 2004 201 972

## Beschreibung

Die Erfindung betrifft ein Schienenverteilersystem,

Aus der DE 199 05 952 C2 ist ein Verteilerkasten bekannt, der eine T-förmige Verkabelung für Starkstrom zur Versorgung von Elektromotoren zugeordneten Umrichtern aufweist. Darüber hinaus ist der Verteilerkasten an einen Feldbus angeschlossen und umfasst eine elektronische Schaltung, die die Feldbusdaten in einen Steuerbus für die angeschlossenen Umrichter umsetzt.

Aus dem Möller-Katalog ,Sichere und flexible Energieverteilungssystem bis 5000 A' aus dem Jahre 2002 sind Schienenverteilersysteme bekannt. Dabei wird von einem zentralen Einspeisepunkt Energie an Verbraucher verteilt, wobei der elektrische Strom über Schienen, also Verteilerschienen, geführt ist und die Abzweigungsstellen als Verteilerkästen ausgeführt sind, die zur Stromweiterleitung mit den Verbrauchern verbunden sind. Die Verteilerkästen werden auf die Schienen aufgesteckt.

Aus der US 5 465 395 A1 ist ein Leckkabelübertragungssystem bekannt, das ein Stahl rohrgehäuse aufweist.

Der Erfindung liegt daher die Aufgabe zugrunde, ein Schienenverteilersystem weiterzubilden, wobei die Verteilerknoten wenig Masse, eine geringe Anzahl von Teilen und eine geringe Störanfälligkeit und zusätzlich bei geringeren Kosten aufweist.

Erfindungsgemäß wird die Aufgabe bei dem Schienenverteilersystem nach den in Anspruch 1 angegebenen Merkmalen gelöst.

Wesentliche Merkmale der Erfindung bei dem Schienenverteilsystem sind, dass es einen zentralen Einspeisepunkt für Energie und Information umfasst, der Verteilerschienen versorgt, wobei ein oder mehrere Verteilerknoten an den Verteilerschienen angeordnet sind, über die Verbraucher mit Energie versorgbar sind und Information austauschbar ist, wobei zur Informationsübertragung ein Leckwellenleiter parallel zu den Verteilerschienen angeordnet ist, der Ausnehmungen zum Durchtritt von elektromagnetischer Strahlung aufweist,
der Verteilerknoten eine Sende- und Empfangseinheit umfasst, welche in einem Abstand zum Leckwellenleiter angeordnet ist,
wobei die ausgetauschten Daten zum angeschlossenen Verbraucher oder zwischen verschiedenenen Verbrauchern über einen Informationskanal austauschbar sind.

Von Vorteil ist dabei, dass keine Komponenten zur galvanischen Trennung zur Datenübertragung notwendig sind, obwohl der Leckwellenleiter parallel zu den Verteilerschienen liegt und somit - insbesondere im Falle eines Fehlers - der Leckwellenleiter das gleiche Potential aufweisen kann wie die Verteilerschienen. Entstörfilter entfallen ebenfalls, da die Energieübertragung mit Netzfrequenz und die Informationsübertragung mit weit mehr als 1 MHZ ausführbar ist.

Bei einer vorteilhaften Ausgestaltung umfasst der Verteilerknoten ein Verteilerkasten, der Leistungstrennkontakte, die mit den Verteilerschienen beim Aufstecken des Verteilerkastens auf einen Schienenträger der Verteilerschienen verbindbar sind, insbesondere aufklipsbar. Von Vorteil ist dabei, dass die Verbindung besonders einfach und schnell ausführbar ist.

Bei einer vorteilhaften Ausgestaltung sind die Ausnehmungen in regelmäßigen Abständen angeordnet. Von Vorteil ist dabei, dass der Verteilerkasten ebenfalls an regelmäßig voneinander beabstandeten Positionen anbringbar ist, wobei eine große Intensität von elektromagnetischer Strahlung vorsehbar ist und somit ein großes Signal-Rausch-Verhältnis.

Bei einer vorteilhaften Ausgestaltung sind die Verteilerschienen zur Übertragung mit mehrphasigem Starkstrom und/oder Mittelspannung ausgeführt.

Bei einer vorteilhaften Ausgestaltung ist der Abstand zwischen dem Leckwellenleiter und der Sende- und Empfangseinheit größer als der Spannungsabstand, also der Abstand der gesetzlich oder nach Norm vorgeschrieben ist bei Komponenten mit entsprechend unterschiedlichem Potential. Von Vorteil ist dabei, dass keine zusätzlichen Komponenten zur galvanischen Trennung notwendig sind und auch Entstörfilter entbehrlich sind.

Weitere Vorteile ergeben sich aus den Unteransprüchen.

### Bezugszeichenliste

- 1: Zentraler Einspeisepunkt für Energie und Information
- 2: mehrphasige elektrische Verteilerschiene
- 3: Leckwellenleiter
- 4: Verteilerkasten
- 5: Leistungskabel
- 6: Informationsleitung oder Informationskanal
- 7: Umrichtermotor
- 21: Schienenträger
- 22: Leiterschienen
- 23: Schirm des Leckwellenleiters
- 24: Ausnehmungen
- 25: Isolator
- 26: Mitteilleiter
- 34: Gehäuse
- 35: Gehäuseboden
- 36: Leistungstrennkontakte
- 37: Sende- und Empfangseinheit

Die Erfindung wird nun anhand von Abbildungen näher erläutert:

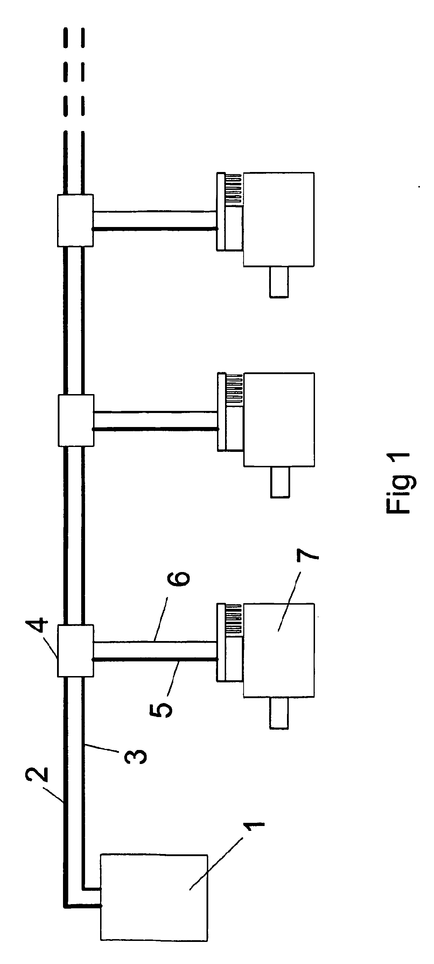

In der Figur 1 ist eine erfindungsgemäße Anlage mit Schienenverteilersystem schematisch skizziert.

Dabei wird von einem zentralen Einspeisepunkt 1 Energie und Information an Verbraucher verteilt, wobei der elektrische Strom über Schienen, also Verteilerschienen 2, geführt ist und die Abzweigungsstellen als Verteilerkästen 4 ausgeführt sind, die zur Stromweiterleitung mit den Verbrauchern verbunden sind. Die Verteilerkästen 4 werden auf die Schienen aufgesteckt. Die Verbraucher sind Umrichtermotoren 7, die dezentral in der Anlage angeordnet sind und somit mit Energie und Information versorgt werden müssen.

Die elektrische Verteilerschiene 2 ist mehrphasig ausgeführt und ein Leckwellenleiter 3 ist parallel zu den Verteilerschienen 2 angeordnet. Von den Verteilerkästen 4 führen Leistungskabel 5 und Informationsleitung 6 zu den Verbrauchern. Die Übertragung der Information von den Verteilerkästen 4 zu den Verbrauchern ist in anderen erfindungsgemäßen Ausführungsbeispielen auch als andersartiger Informationskanal ausführbar, beispielsweise durch Aufmodulation auf die Leistungskabel.

Als Verbraucher sind Umrichtermotoren 7 gezeigt. Jedoch sind auch beliebige andere Verbraucher mit Energie und Information versorgbar.

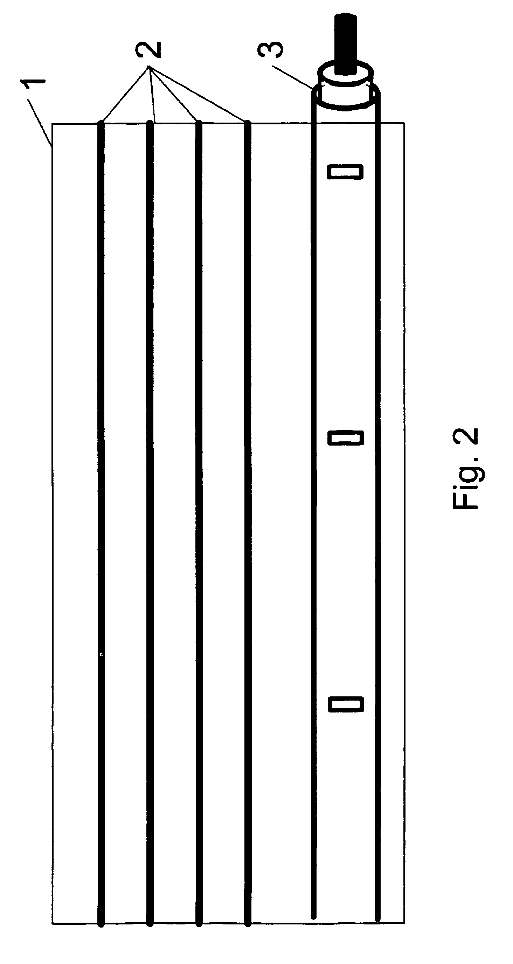

In Figur 2 ist der Aufbau der elektrischen Verteilerschiene 2 schematisch skizziert. Dabei ist der Schienenträger 21 mit vier Leiterschienen 22 und einem Leckwellenleiter verbunden, also zur Drehstromübertragung zusammen mit Nullleiter. Der Mitteilleiter 26 ist von einem Isolator 25 umgeben. Der Schirm 23 des Leckwellenleiters weist Ausnehmungen 24 auf, aus denen hochfrequente elektromagnetische Strahlung austreten kann. Beispielsweise ist als Leckwellenleiter ein entsprechend geschlitzter Koaxialleiter verwendbar.

Bei anderen erfindungsgemäßen Ausführungsbeispielen sind die Ausnehmungen auch anders formbar und in unregelmäßigen oder auch wiederum regelmäßigen Abständen anordenbar.

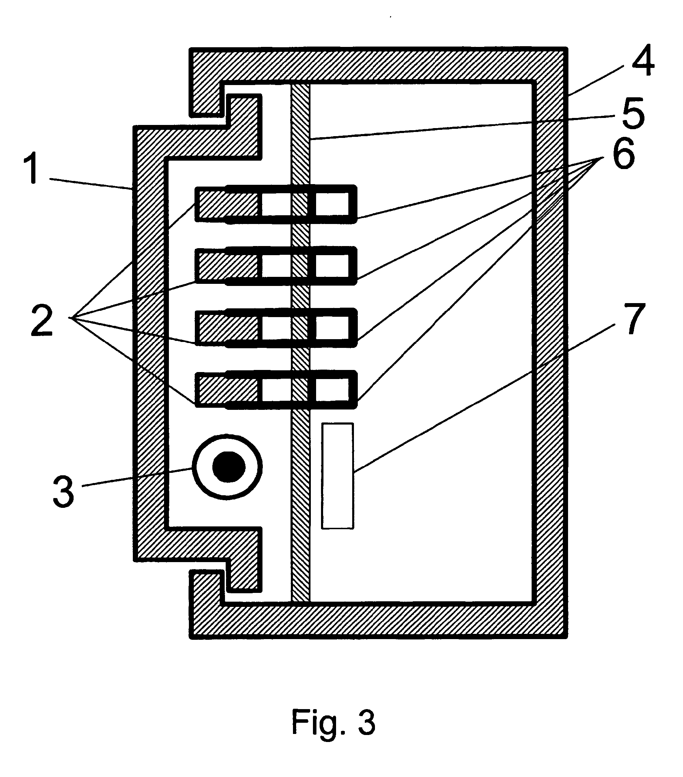

In Figur 3 ist ein schematischer Querschnitt durch einen Verteilerkasten gezeigt, wobei das Gehäuse 34 mit einem Gehäuseboden 35 verbunden ist, auf welchem eine Sende- und Empfangseinheit 37 und Leistungstrennkontakte 36 angebracht sind.

Beim Aufstecken des Gehäuses 34 auf den Schienenträger 21 werden die Leistungstrennkontakte 36 mit den Leiterschienen 22 verbunden, insbesondere aufgeklipst. Die Sende- und Empfangseinheit 37 ist über dem Leckwellenleiter positioniert und empfängt die aus den Ausnehmungen 24 austretende elektromagnetische Strahlung beziehungsweise strahlt diese durch die Ausnehmungen in das Innere des Leckwellenleiters ein. Somit sind Daten berührungslos austauschbar. Durch den räumlichen Abstand zwischen Sende- und Empfangseinheit 37 und Leckwellenleiter ist eine elektrische Isolierung zwischen den beiden Komponenten unnötig.

Vorteiligerweise sind also bei der Erfindung aufwendige elektrische Isolierungen einsparbar

Insgesamt weist also der Verteilerkasten, der auch unter den Oberbegriff Verteilerknoten fällt, ein integrierte Sende- und Empfangsantenne auf. Der Leckwellenleiter ist parallel zu den schienen montiert und die Informationsübertragung mittels Kurzstreckenfunk realisiert, wobei gleichzeitig eine galvanische Trennung erreicht ist und Verdrahtungsaufwand für Datenleitungen entfällt.

Die Informationsübertragung läuft im Wesentlichen störungsfrei, da die elektrische Leistung mit Niederfrequenz oder Netzfrequenz, also beispielsweise 50 Hz oder 60 Hz, erfolgt. Die vorteilhaften Frequenzen für die Informationsübertragung liegen weit über 1 MHz, insbesondere im GHz-Bereich. Entstörfilter für die Datenübertragung sind also ebenso entbehrlich wie die galvanische Trennung. Gefahr der Potentialverschleppung ist ebenfalls gebannt.

Bei einer vorteilhaften anderen Ausführung umfasst der Verteilerkasten eine elektronische Schaltung oder Gateway, das derart ausgeführt ist, dass mit dem Leckwellenleiter Feldbusdaten austauschbar sind und in Systembusdaten umgesetzte Daten mit dem Verbraucher hin austauschbar sind.

## Patentansprüche

1. Schienenverteilersystem,
umfassend einen zentralen Einspeisepunkt für Energie und Information, der Verteilerschienen versorgt,
wobei ein oder mehrere Verteilerknoten an den Verteilerschienen angeordnet sind, über die Verbraucher mit Energie versorgbar sind und Information austauschbar ist,
**dadurch gekennzeichnet, dass**
zur Informationsübertragung ein Leckwellenleiter parallel zu den Verteilerschienen angeordnet ist, der Ausnehmungen zum Durchtritt von elektromagnetischer Strahlung aufweist,
der Verteilerknoten eine Sende- und Empfangseinheit umfasst, welche in einem Abstand zum Leckwellenleiter angeordnet ist,
wobei die ausgetauschten Daten zum angeschlossenen Verbraucher oder zwischen verschiedenenen Verbrauchern über einen Informationskanal austauschbar sind.

2. Schienenverteilersystem nach mindestens einem der vorangegangenen Ansprüche,
**dadurch gekennzeichnet, dass**
der Verteilerknoten ein Verteilerkasten ist, der Leistungstrennkontakte umfasst, die mit den Verteilerschienen beim Aufstecken des Verteilerkastens auf einen Schienenträger der Verteilerschienen verbindbar sind, insbesondere aufklipsbar.

3. Schienenverteilersystem nach mindestens einem der vorangegangenen Ansprüche,
**dadurch gekennzeichnet, dass**
die Ausnehmungen in regelmäßigen Abständen angeordnet sind.

4. Schienenverteilersystem nach mindestens einem der vorangegangenen Ansprüche,
**dadurch gekennzeichnet, dass**
die Verteilerschienen zur Übertragung mit mehrphasigem Starkstrom ausgeführt sind.

5. Schienenverteilersystem nach mindestens einem der vorangegangenen Ansprüche,
**dadurch gekennzeichnet, dass**
der Abstand zwischen dem Leckwellenleiter und der Sende- und Empfangseinheit größer ist als der Spannungsabstand, also der Abstand der gesetzlich oder nach Norm vorgeschrieben ist bei Komponenten mit entsprechend unterschiedlichem Potential.

## Claims

1. Busbar trunking system,
comprising a central feeding point for power and information which supplies distribution busbars,
one or more distribution nodes being arranged on the distribution busbars, via which consumers can be supplied with power and information can be exchanged,
**characterised in that**
for the information transmission a leaky waveguide having apertures for the passage of electromagnetic radiation is arranged parallel to the distribution busbars,
the distribution node comprises a transmitting and receiving unit arranged at a distance from the leaky waveguide,
the data exchanged with the connected consumer or between different consumers being exchangeable via an information channel.

2. Busbar trunking system according to at least one of the preceding claims,
**characterised in that**
the distribution node is a distribution box comprising power isolating contacts which can be connected to the distribution busbars when fitting the distribution box onto a busbar carrier of the distribution busbars, in particular clipped on.

3. Busbar trunking system according to at least one of the preceding claims,
**characterised in that**
the apertures are arranged at regular intervals.

4. Busbar trunking system according to at least one of the preceding claims,
**characterised in that**
the distribution busbars are designed for transmission with multi-phase heavy current.

5. Busbar trunking system according to at least one of the preceding claims,
**characterised in that**
the distance between the leaky waveguide and the transmitting and receiving unit is greater than the minimum clearance, i.e. the distance as prescribed by law or by standard between components with correspondingly different potential.

## Revendications

1. Système de distribution à barres,
comprenant un point d'alimentation central pour de l'énergie et de l'information qui alimente des barres de distribution,
un ou plusieurs noeuds de distribution étant disposés sur les barres de distribution, par lesquels les consommateurs peuvent être alimentés en énergie et de l'information peut être échangée,
**caractérisé par le fait que**
un guide d'ondes à ondes de fuite est disposé parallèlement aux barres de distribution pour la transmission d'information, lequel présente des évidements pour le passage de rayonnement électromagnétique,
le noeud de distribution comprend une unité d'émission et de réception qui est disposée à distance du guide d'ondes à ondes de fuite,
les données échangées avec le consommateur raccordé ou entre différents consommateurs pouvant être échangées via un canal d'information.

2. Système de distribution à barres selon au moins l'une des revendications précédentes,
**caractérisé par le fait que**
le noeud de distribution est un coffret de distribution qui comprend des contacts de coupure de puissance qui peuvent être reliés, en particulier clipsés avec les barres de distribution lors du montage du coffret de distribution sur un support de barres des barres de distribution.

3. Système de distribution à barres selon au moins l'une des revendications précédentes,
**caractérisé par le fait que**
les évidements sont disposés à intervalles réguliers.

4. Système de distribution à barres selon au moins l'une des revendications précédentes,
**caractérisé par le fait que**
les barres de distribution sont conçues pour le transport de courant fort polyphasé.

5. Système de distribution à barres selon au moins l'une des revendications précédentes,
**caractérisé par le fait que**
la distance entre le guide d'ondes à ondes de fuite et l'unité d'émission et de réception est plus grande que la distance entre conducteurs, c'est-à-dire la distance qui est prescrite par la loi ou selon une norme entre des composants à un potentiel différent correspondant.
